# EUROPEAN PATENT SPECIFICATION

(11) **EP 2 551 692 B1**
(45) Date of publication and mention of the grant of the patent: **02.03.2016**
(21) Application number: 11759039.8
(22) Date of filing: 25.03.2011
(51) Int. Cl.: G01R 33/30, G01R 33/31, G01R 33/32, G01R 33/34, G01R 33/38, G01R 33/3875, G01R 33/465, G01R 33/36

(54) **NMR ANALYZER FOR LABORATORY TESTS**
NMR-ANALYSEGERÄT FÜR LABORTESTS
ANALYSEUR PAR RÉSONANCE MAGNÉTIQUE NUCLÉAIRE POUR TESTS DE LABORATOIRE

(30) Priority: 25.03.2010 JP 2010070568
(43) Date of publication of application: 30.01.2013
(73) Proprietor: Kabushiki Kaisha Kobe Seiko Sho, Kobe-shi, Hyogo 651-8585 (JP)
(72) Inventor: MIKI, Takashi, Hyogo 651-2271 (JP); TERAO, Yasuaki, Hyogo 651-2271 (JP)
(74) Representative: Müller-Boré & Partner Patentanwälte PartG mbB
(86) International application number: PCT/JP2011/001779
(87) International publication number: WO 2011/118230

(56) References cited:
- EP-A2- 1 666 907
- WO-A1-2007/057709
- JP-A- 2005 210 015
- JP-A- 2007 531 884
- JP-A- 2009 020 095
- US-A1- 2005 202 976

## Description

### Technical Field

The present invention relates to an NMR (Nuclear Magnetic Resonance) analyzer for clinical examinations for analyzing a liquid component extracted from a human body.

### Background Art

Conventionally, NMR analyzers are known which comprise: a superconducting magnet for generating a powerful static magnetic field inside an arrangement space in which a sample is arranged; a liquid helium tank which houses the superconducting magnet and liquid helium for cooling the superconducting magnet; a liquid nitrogen tank which is provided on the outside of the arrangement space across the liquid helium tank and which houses liquid nitrogen; and a main body container which houses the liquid helium tank and the liquid nitrogen tank and which is formed in a ring-shape and compartmentalizes the arrangement space (for example, Patent Document 1). The liquid nitrogen tank is provided in order to suppress intrusion of heat from the outside into the liquid helium tank.

NMR analyzers of this type are used at research institutes, chemical substance manufacturing sectors, and the like for identifying synthesized or separated chemical substances and other purposes.

Meanwhile, in recent years, the use of NMR analyzers at medical facilities for analyzing liquid components extracted from a human body including blood, urine, sweat, saliva, spinal fluid, and organ extraction liquids is being considered.

However, with a conventional NMR analyzer such as that described in Patent Document 1, in order to prevent the intrusion of heat from the outside to a liquid helium tank that houses a superconducting magnet, a liquid nitrogen tank is provided on the outside of a sample chamber across the liquid helium tank. As a result, the NMR analyzer is too large to be used in medical facilities with limited installation space.

Patent Document 1: Japanese Patent Application Laid-open No. 2007-51850 Document EP 1 666 907 A2 discloses a flow-through sample container, or flow cell, which resides with the channel of magnetic resonance probe without being fixed thereto. The flow cell is removable from the spectrometer while leaving the probe in place, allowing easy cleaning of the probe channel and replacement of the flow cell. An insertion tool that houses the flow cell may be used to safely introduce it to the probe. Input and output capillaries serve as fluid pathways for fluid samples entering and leaving the flow cell, respectively. These capillaries may be connected to the flow cell with a manually operable connector, allowing easy disconnection of the flow cell from the input and output conduit. The capillaries enter through different ends of the spectrometer bore, so that the fluid samples flow enter one end of the spectrometer and exit through the other. Document WO 2007/057709 A1 discloses a superconducting magnet system comprising an annular cryogenic vessel having an outer vacuum container and containing a superconducting magnet within an annular reservoir containing liquid helium. A cryocooler has a first stage linked by a thermal link to a thermal shield within the vacuum space surrounding the reservoir and a second stage that serves to recondense evaporating helium gas from the reservoir. An inertial shield is provided between the reservoir and the thermal shield in such a position that the outgoing helium gas from the reservoir carries away the heat being transferred to the inertial shield from the thermal shield and thus slows down the rate at which the thermal inertial shield warms up.

### Summary of the Invention

An object of the present invention is to provide a compact NMR analyzer for clinical examinations which is suitable for use at medical facilities.

In order to solve the problem described above, the present invention provides an NMR analyzer for clinical examinations for analyzing a liquid sample including a liquid component extracted from a human body, the NMR analyzer for clinical examinations comprising: a solution feeding device that is configured to feed a liquid sample; a solution feeding pipe that is configured to receive the liquid sample fed from the solution feeding device and to derive the liquid sample in accordance with a feeding operation of the solution feeding device; a superconducting magnet that encloses, around an axis of the solution feeding pipe, a housing space surrounded by a side wall of the solution feeding pipe such that a static magnetic field can be generated inside the housing space along the axis of the solution feeding pipe; a housing container that houses the superconducting magnet and a coolant for cooling the superconducting magnet and that encloses the housing space around the axis of the solution feeding pipe; a main body container that has a negative pressure chamber whose interior is set to a negative pressure and that houses the housing container inside the negative pressure chamber and holds the solution feeding pipe by enclosing the solution feeding pipe around the axis thereof; a covering container that covers the housing container inside the negative pressure chamber, a cooling device that is configured to recondense a coolant vaporized inside the housing container and to cool the covering container; a magnetic field correcting coil that is provided between the main body container and the solution feeding pipe and that is configured to correct the static magnetic field generated inside the housing space by the superconducting magnet; a resonant circuit that includes a detecting coil enclosing the housing space around the axis of the solution feeding pipe between the solution feeding pipe and the magnetic field correcting coil, and is configured to apply high-frequency electromagnetic waves to a liquid sample inside the housing space, and to detect an NMR signal from the liquid sample; a transmitting/receiving unit that is configured to supply high-frequency power to the resonant circuit and to receive an NMR signal from the resonant circuit; a signal analyzing unit that is configured to create data regarding a relationship between frequency and signal intensity based on the NMR signal received by the transmitting/receiving unit; a pair of upper and lower fixing plates holding the solution feeding pipe; insertion holes respectively formed in the fixing plates, the insertion holes vertically penetrating the fixing plates in order to allow the solution feeding pipe to be inserted; and vertically-penetrating holes formed in the fixing plates in addition to the insertion holes, through which air can be pumped for temperature control of the solution feeding pipe; wherein cooling of the covering container by the cooling device suppresses intrusion of heat from the outside into the housing container that is covered by the covering container, and by sequentially feeding a plurality of liquid samples of different types by the solution feeding device into the housing space, NMR signals of liquid samples inside the housing space can be sequentially detected.

According to the present invention, a compact NMR analyzer for clinical examinations which is suitable for use at medical facilities can be provided.

### Brief Description of the Drawings

[Fig. 1] Fig. 1 is a front sectional view schematically showing an overall configuration of a flow-through NMR analyzer according to an embodiment of the present invention.
[Fig. 2] Fig. 2 is a front sectional view showing an enlargement of a part of the NMR analyzer shown in Fig. 1.
[Fig. 3] Fig. 3 is a front sectional view in which a probe shown in Fig. 2 has been omitted.
[Fig. 4] Fig. 4 is a front sectional view showing an enlargement of the probe shown in Fig. 2.
[Fig. 5] Fig. 5 is a perspective view showing an enlargement of an RF coil shown in Fig. 2.
[Fig. 6] Fig. 6 is a block diagram showing an electrical configuration of a spectrometer shown in Fig. 1.
[Fig. 7] Figs. 7 are diagrams showing an NMR signal transform process that is executed by a signal analyzing unit shown in Fig. 6, wherein Fig. 7A shows a state prior to transform, and Fig. 7B shows a state after the transform.

### Mode for Carrying Out the Invention

Hereinafter, an embodiment of the present invention will be described with reference to the accompanying drawings. The following embodiment is merely one specific example of the present invention and is not intended to limit the technical scope of the present invention.

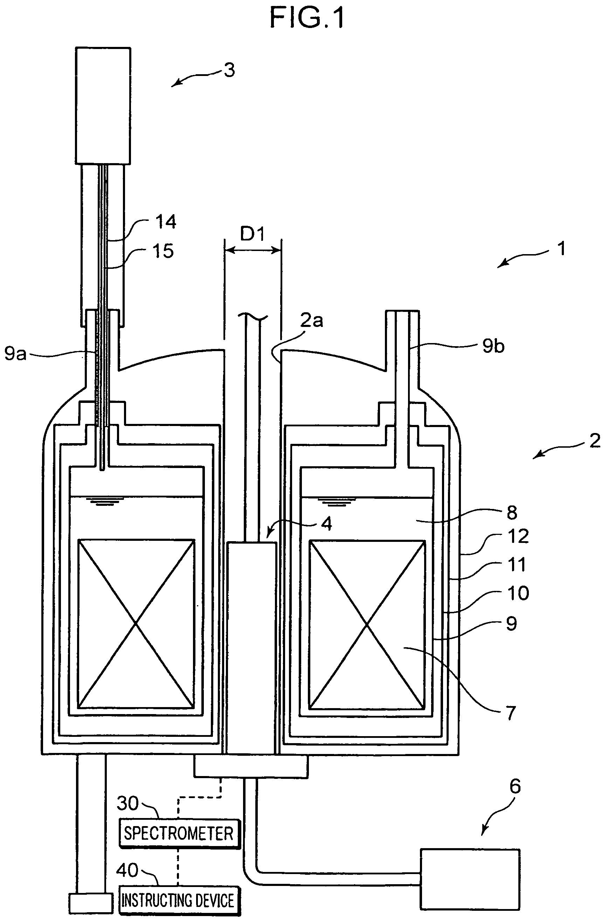

Fig. 1 is a front sectional view schematically showing an overall configuration of an NMR analyzer for clinical examinations according to an embodiment of the present invention.

With reference to Fig. 1, an NMR analyzer for clinical examinations (hereinafter, referred to as an NMR analyzer) 1 is for analyzing a liquid sample including a liquid component extracted from a human body. As used herein, "a liquid component extracted from a human body" is a term encompassing blood, urine, sweat, saliva, spinal fluid, organ extraction liquid, and the like.

Specifically, the NMR analyzer 1 comprises: a magnetic field generating unit 2 for generating a static magnetic field inside a first through hole 2a; a recondensing unit (cooling device) 3 provided in the magnetic field generating unit 2 for recondensing a coolant that had vaporized in the magnetic field generating unit 2; a magnetic field correcting unit 4 for correcting homogeneity of a magnetic field in the first through hole 2a; a probe 5 provided in the magnetic field correcting unit 4 for holding a sample inside the first through hole 2a; a solution feeding pump (solution feeding device) 6 for feeding a sample to the probe 5; and a spectrometer 30 and an instructing device 40 which are electrically connected to the probe 5. In the present embodiment, a diameter D1 of the first through hole 2a of the magnetic field generating unit 2 is set to 20 mm.

The magnetic field generating unit 2 comprises: a tubular superconducting magnet 7; a helium container (housing container) 9 which houses the superconducting magnet 7 and a coolant (for example, liquid helium) 8 for cooling the superconducting magnet 7; a vacuum container (main body container) 12 which internally forms a vacuum chamber and which houses the helium container 9 inside the vacuum chamber; and a heat shield (covering container) 10 and a heat shield (covering container) 11 which enclose the helium container 9 between the helium container 9 and the vacuum container 12 in order to suppress thermal radiation from the vacuum container 12 (intrusion of heat into the helium container 9). The helium container 9 has two neck tubes 9a and 9b that extend upward. The heat shields 10 and 11 are respectively thermally connected to midsections of the neck tubes 9a and 9b. In addition, upper end sections of the neck tubes 9a and 9b respectively penetrate the vacuum container 12 and are opened to above. The recondensing unit 3 is attached to the neck tube 9a. Meanwhile, in the present embodiment, a lid (not shown) is attached to the neck tube 9b and closes the upper opening of the neck tube 9b. Alternatively, by providing another recondensing unit 3 on the neck tube 9b, efficiency of recondensation of liquid helium can be increased.

The recondensing unit 3 is for recondensing helium that vaporizes in the helium container 9 and rises in the neck tube 9a and for cooling the respective heat shields 10 and 11. Specifically, the recondensing unit 3 comprises: a two-stage cooling machine having a first stage set to a temperature of 30 K to 50 K and a second stage set to a temperature of 3 K to 4.5 K; a first sleeve 14 thermally connected to the first stage of the cooling machine; and a second sleeve 15 which is provided on an inner side of the first sleeve 14 and which is thermally connected to the second stage of the cooling machine. The first sleeve 14 is inserted into the neck tube 9a of the helium container 9 and, at the same time, thermally connected to an inner surface of the neck tube 9a at a contact position with the heat shields 10 and 11. The second sleeve 15 extends further downward than the first sleeve 14 and a tip section thereof is arranged in a vicinity of a liquid level of the liquid helium 8. In addition, the recondensing unit 3 uses the first sleeve 14 to cool the heat shields 10 and 11 via the neck tube 9a and uses the second sleeve 15 to recondense the vaporized helium and return the recondensed helium to the helium container 9. As described above, since the heat shields 10 and 11 are cooled via the neck tube 9a in the NMR analyzer 1 according to the present embodiment, a container for housing a coolant (for example, liquid nitrogen) need not be separately provided outside the helium container 9.

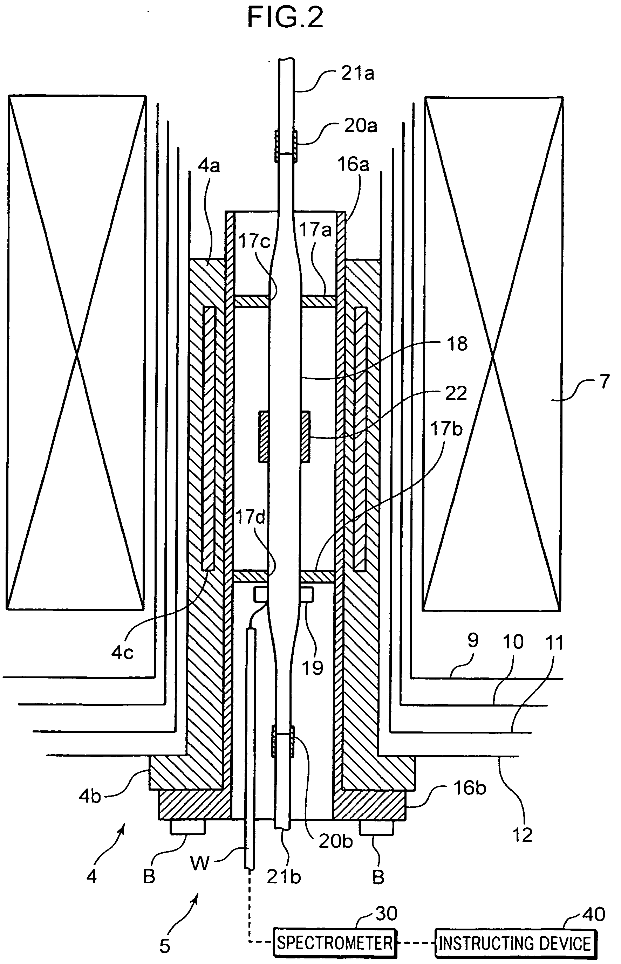

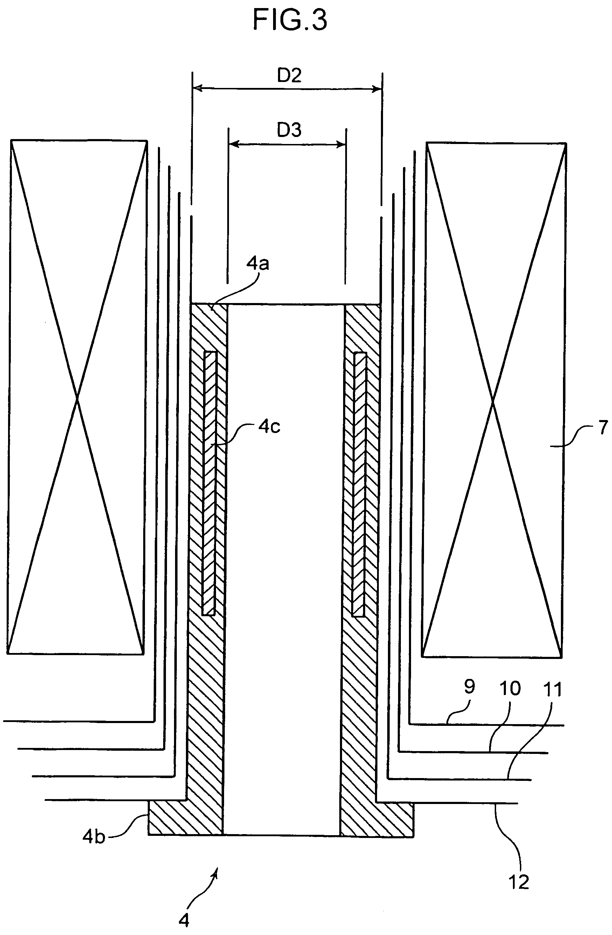

Fig. 2 is a front sectional view showing an enlargement of a part of the NMR analyzer 1 shown in Fig. 1. Fig. 3 is a front sectional view in which the probe 5 shown in Fig. 2 has been omitted.

With reference to Figs. 2 and 3, the magnetic field correcting unit 4 comprises: a tubular section 4a inserted into the first through hole 2a of the magnetic field generating unit 2; a flange section 4b that protrudes outward from a lower end section of the tubular section 4a; and a magnetic field correcting coil 4c embedded inside the tubular section 4a. By inserting the tubular section 4a into the first through hole 2a until an upper surface of the flange section 4b abuts a lower surface of the vacuum container 12, the magnetic field correcting coil 4c is arranged at a position on an inner side of the superconducting magnet 7. A part of the tubular section 4a enclosed by the superconducting magnet 7 is made of FRP (Fiber Reinforced Plastics), and a part of the tubular section 4a below the superconducting magnet 7 is made of aluminum. The flange section 4b is also made of aluminum. In the present embodiment, an outside diameter D2 of the tubular section 4a is 19.8 mm and an inside diameter D3 of the tubular section 4a is 10 mm. Furthermore, a vertical length of the magnetic field correcting coil 4c is 40 mm.

The magnetic field correcting coil 4c is made of copper and is embedded in the tubular section 4a. The magnetic field correcting coil 4c is for generating a magnetic field such that an intensity of the magnetic field at a center position of the first through hole 2a remains constant regardless of the passage of time. Specifically, since the intensity of the magnetic field generated by the superconducting magnet 7 attenuates in proportion to elapsed time, the magnetic field correcting coil 4c generates a magnetic field that compensates for the attenuation amount of the intensity of the magnetic field. Moreover, the attenuation of the magnetic field intensity of the superconducting magnet 7 is detected by the spectrometer 30 (to be described later) based on a variation over time of a central frequency of an NMR signal of a reference substance. Examples of the reference substance include deuterium (2H) included in a deuterated solvent that is used as a solvent for a measurement object substance. Alternatively, the magnetic field correcting coil 4c may be constituted by a conducting wire wound around the tubular section 4a.

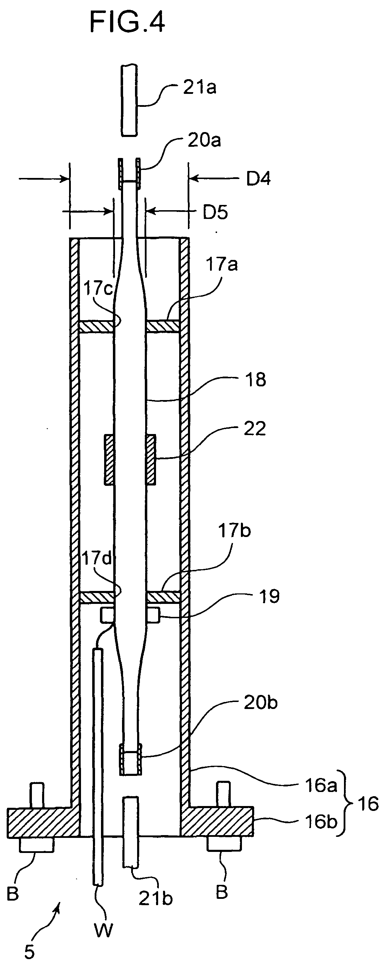

Fig. 4 is a front sectional view showing an enlargement of the probe 5 shown in Fig. 2.

With reference to Figs. 2 and 4, the probe 5 comprises: a mounting member 16 mounted to the magnetic field correcting unit 4 in a state where the mounting member 16 is inserted into a hole in the tubular section 4a of the magnetic field correcting unit 4; a pair of upper and lower fixing plates 17a and 17b formed on an inner side of the mounting member 16; a solution feeding pipe 18 held by the fixing plates 17a and 17b; an RF coil (detecting coil) 22 integrally formed with a side wall of the solution feeding pipe 18 in a region enclosed by the superconducting magnet 7 and the magnetic field correcting coil 4c among the solution feeding pipe 18; a circuit section 19 electrically connected to the RF coil 22; a coaxial cable W connected between the circuit section 19 and the spectrometer 30 (to be described later); and connecting sections 20a and 20b provided on both ends of the solution feeding pipe 18.

The mounting member 16 integrally comprises a tubular body 16a inserted into the tubular section 4a of the magnetic field correcting unit 4 and a flange section 16b that protrudes outward from a lower end section of the tubular body 16a. In addition, the mounting member 16 is made of aluminum. The mounting member 16 is fixed to the magnetic field correcting unit 4 by screwing a bolt B into a female screw section (not shown) formed at both flange sections 4b and 16b in a state where an upper surface of the flange section 16b abuts a lower surface of the flange section 4b of the magnetic field correcting unit 4. The mounting member 16 can be detached from the magnetic field correcting unit 4 by unscrewing the bolt B. In the present embodiment, an outside diameter dimension D4 of the tubular body 16a is 9.8 mm.

The fixing plates 17a and 17b are fixed to an inner surface of the tubular body 16a at an interval corresponding to a length of the magnetic field correcting coil 4c , in other words, at an interval of 40 mm. Insertion holes 17c and 17d which vertically penetrate the fixing plates 17a and 17b in order to allow the solution feeding pipe 18 to be inserted are respectively formed in the fixing plates 17a and 17b. By forming vertically-penetrating holes in the fixing plates 17a and 17b in addition to the insertion holes 17c and 17d, air can be pumped into the probe 5 using a blower (not shown). As a result, temperature control of the solution feeding pipe 18 can be performed.

A midsection of the solution feeding pipe 18 is enclosed by the superconducting magnet 7, the vacuum container 12, and the magnetic field correcting coil 4c around the axis of the solution feeding pipe 18. Therefore, a static magnetic field along an axial direction of the solution feeding pipe 18 is applied by the superconducting magnet 7 to a sample inside the solution feeding pipe 18. Specifically, the solution feeding pipe 18 is a cylindrical glass pipe fixed to the respective fixing plates 17a and 17b in a state where the solution feeding pipe 18 is inserted into the insertion holes 17c and 17d. A sample housing space enclosed by a cylindrical side wall is formed in the solution feeding pipe 18. As shown, in the present embodiment, NMR signals of samples sequentially fed into the solution feeding pipe 18 (housing space) that is fixed to the magnetic field generating unit 2 can be detected. Therefore, unlike a conventional configuration in which NMR signals are detected by replacing test tubes for each sample, the entire NMR analyzer 1 can be downsized. Specifically, with a conventional NMR device that uses a test tube, homogeneity of a magnetic field in an NMR signal detection area may become unstable due to a mounting position of the test tube. For this reason, a rotating device for rotating the test tube around an axis thereof (for example, an air introducing unit for blowing air against a fin formed on the test tube) is required to suppress destabilization of the homogeneity of the magnetic field. In contrast, with the NMR analyzer 1 according to the present embodiment, since NMR signals of a plurality of samples can be detected using a solution feeding pipe fixed to the NMR analyzer 1, the rotating device can be omitted. As shown, with the NMR analyzer 1 according to the present embodiment, a rotating device and a container that houses liquid nitrogen for suppressing the intrusion of heat into the helium container 9 as described earlier can be omitted.

Furthermore, the solution feeding pipe 18 is shaped such that both end sections thereof are thinner than the midsection thereof which is fixed by the respective fixing plates 17a and 17b. In addition, an outside diameter dimension D5 of the midsection of the solution feeding pipe 18 is 3 mm. The RF coil 22 is provided at a position of the solution feeding pipe 18 between the respective fixing plates 17a and 17b.

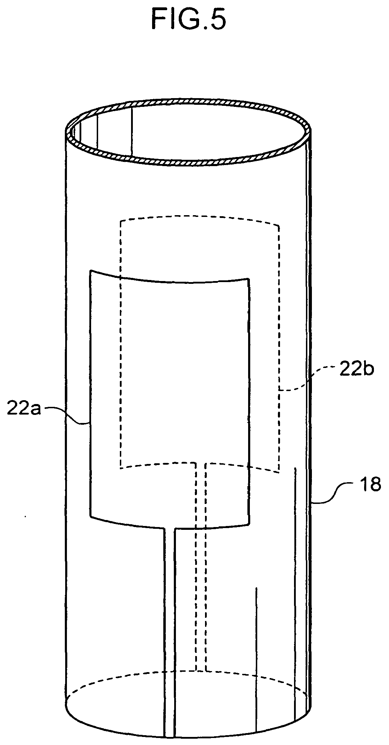

Fig. 5 is a perspective view showing an enlargement of the RF coil 22 shown in Fig. 2.

With reference to Figs. 4 and 5, the RF coil 22 is for applying high-frequency electromagnetic waves to a sample inside the solution feeding pipe 18 and for detecting an NMR signal from the sample. Specifically, the RF coil 22 comprises two coils 22a and 22b provided at a 180-degree interval around the axis of the solution feeding pipe 18. The coils 22a and 22b have a so-called saddle-shape. Specifically, with the coils 22a and 22b, respective upper parts thereof have an approximately rectangular shape in which a side facing downward among each rectangle is split midway to constitute a pair of lead sections respectively extending downward. The lead sections of the coils 22a and 22b are respectively electrically connected to a circuit section 19. In the present embodiment, the RF coil 22 is formed on an outer surface of the solution feeding pipe 18 by patterning (depositing) copper on the outer surface of the solution feeding pipe 18 in the saddle shape. The RF coil 22 preferably has a thickness that is equal to or greater than three times a surface penetration depth of a frequency during an observation. For example, when the material of the RF coil 22 is copper and the frequency during observation is 400 MHz, the thickness of the RF coil 22 is preferably set to 10 to 20 µm. Moreover, while a configuration in which the RF coil 22 is directly formed on the outer surface of the solution feeding pipe 18 has been described in the embodiment described above, the present invention is not limited thereto. For example, the RF coil 22 may alternatively be provided at a different portion (for example, the mounting member 16) from the solution feeding pipe 18. In this case, preferably, a portion positioned between both fixing plates 17a and 17b among the mounting member 16 is constituted by FRP (Fiber Reinforced Plastics) and the RF coil 22 is provided in this portion.

With reference to Fig. 4, the circuit section 19 comprises a capacitor and a coil (not shown), and constitutes a resonant circuit by being connected to the RF coil 22. While the resonant circuit constituted by the RF coil 22 and the circuit section 19 may resonate at a single frequency, the resonant circuit preferably resonates at a plurality of frequencies (for example, when a center of the static magnetic field generated by the superconducting magnet 7 is 9.39 T, since a 1H resonant frequency is 399.952 MHz and a 2 H resonant frequency is 61.395 MHz, the resonant circuit may resonate at 399.952 MHz and 61.395 MHz). Power is supplied to the circuit section 19 via a coaxial wire W and, at the same time, an NMR signal obtained from a sample is transmitted via the coaxial wire W to the spectrometer 30.

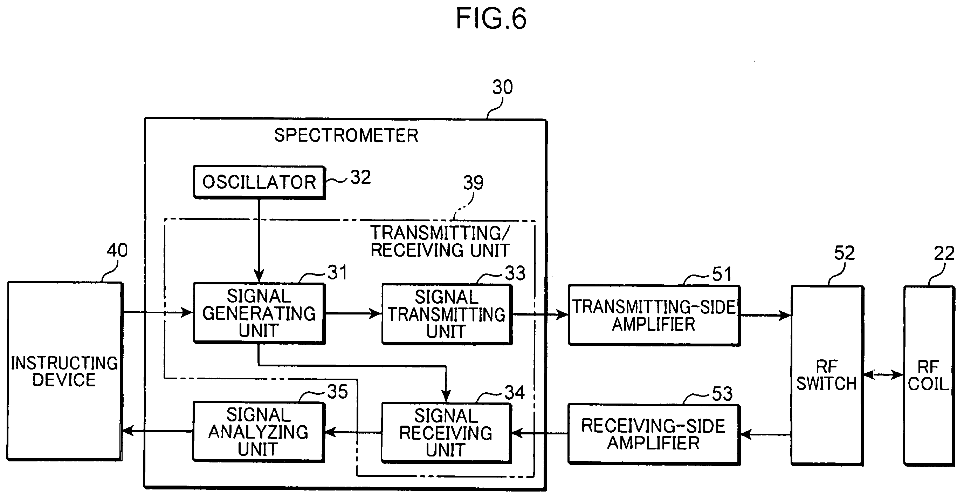

Fig. 6 is a block diagram showing an electrical configuration of the spectrometer shown in Fig. 1.

With reference to Fig. 6, the RF coil 22 is connected to the spectrometer 30 via an RF switch 52, a transmitting-side amplifier 51, and a receiving-side amplifier 53. The RF switch 52 switches signal paths depending on whether a signal is transmitted or received. Specifically, the RF switch 52 connects the RF coil 22 and the transmitting-side amplifier 51 with each other when a signal with a transmission frequency is received, and connects the RF coil 22 and the receiving-side amplifier 53 with each other when a signal with a reception frequency is received. In addition, the transmitting-side amplifier 51 amplifies signals outputted from the spectrometer 30. Furthermore, the receiving-side amplifier 53 amplifies signals outputted from the RF switch 52.

The spectrometer 30 comprises: an oscillator 32 that outputs a high-frequency signal with a predetermined frequency; a signal generating unit 31 that generates a signal that is outputted to the RF coil 22 based on the high-frequency signal from the oscillator 32; a signal transmitting unit 33 that transmits the signal generated by the signal generating unit 31 to the transmitting-side amplifier 51; a signal receiving unit 34 that receives an NMR signal from the RF coil 22 after a predetermined amount of time has elapsed from the timing of signal generation by the signal generating unit 31; and a signal analyzing unit 35 that analyzes the NMR signal received by the signal receiving unit 34. In the present embodiment, the signal generating unit 31, the signal transmitting unit 33, and the signal receiving unit 34 correspond to a transmitting/receiving unit 39.

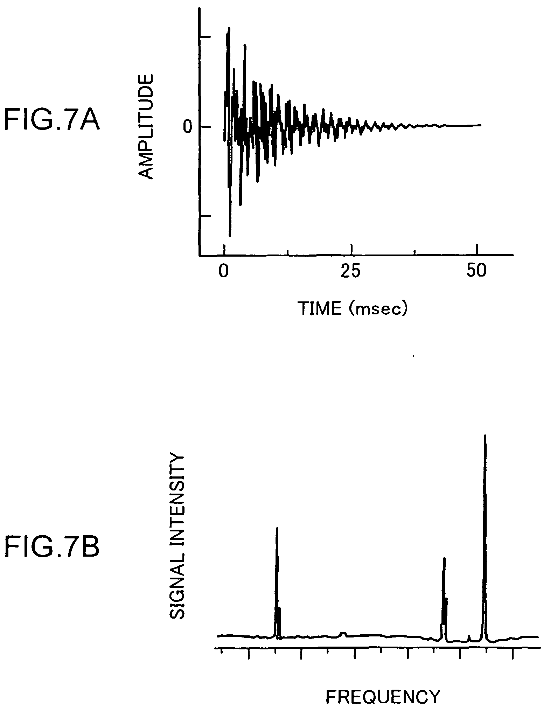

Figs. 7 are diagrams showing an NMR signal transform process that is executed by the signal analyzing unit shown in Fig. 6, wherein Fig. 7A shows a state prior to transform, and Fig. 7B shows a state after the transform.

As shown in Fig. 7A, an NMR signal inputted from the signal receiving unit 34 to the signal analyzing unit 35 represents a magnitude of amplitude with respect to a time axis. The signal analyzing unit 35 transforms (by Fourier transform) the NMR signal into a chart representing signal intensity with respect to a frequency axis as shown in Fig. 7B.

The instructing device 40 instructs the spectrometer 30 to detect NMR signals. Specifically, since the NMR analyzer 1 according to the present embodiment is configured to perform a plurality of NMR signal detections per sample, the instructing device 40 is configured to instruct timings of the plurality of detections. In addition, the instructing device 40 comprises a display unit (not shown) for displaying the chart shown in Fig. 7B that is obtained from the spectrometer 30.

Once again with reference to Figs. 2 and 4, the connecting sections 20a and 20b provided at both ends of the solution feeding pipe 18 are for respectively connecting the solution feeding tube (discharge line) 21a and the solution feeding tube (feed line) 21b to the solution feeding pipe 18. Specifically, the connecting section 20b detachably connects the solution feeding tube 21b connected to the solution feeding pump 6 to the lower end section of the solution feeding pipe 18. In addition, the connecting section 20a detachably connects the solution feeding tube 21a connected to a sample recovery unit (not shown) to the upper end section of the solution feeding pipe 18.

The solution feeding pump 6 is configured so as to be capable of alternately feeding a sample and a cleaning solution. Therefore, using the solution feeding pump 6 enables a plurality of samples of different types to be sequentially fed into the solution feeding pipe 18. The cleaning solution is for washing away the sample of a previous detection which remains inside the solution feeding pipe 18.

As described above, the present embodiment comprises the recondensing unit 3 that cools the heat shields 10 and 11. Therefore, by cooling the heat shields 10 and 11 with the recondensing unit 3, intrusion of heat from the outside into the helium container 9 that is covered by the heat shields 10 and 11 can be suppressed. As a result, according to the embodiment described above, a liquid nitrogen container need not be separately provided outside the helium container 9 as was conventional, and a configuration more compact than conventional NMR analyzers with a liquid nitrogen container can be achieved.

Furthermore, in the embodiment described above, a sample can be fed from the solution feeding pump 6 into the solution feeding pipe 18, and an NMR signal of the sample inside the solution feeding pipe 18 can be acquired. Therefore, by sequentially feeding a plurality of samples of different types into the housing space by the solution feeding pump 6, NMR signals of the respective samples can be sequentially detected. As a result, according to the embodiment described above, a compact configuration can be achieved in comparison to conventional NMR analyzers in which samples of a plurality of types are respectively placed in different test tubes and NMR signals are acquired by sequentially replacing the test tubes. Specifically, a conventional NMR analyzer using test tubes requires attaching and detaching the test tubes to and from the analyzer. In such a case, since mounting positions of test tubes to the analyzer cannot be accurately adjusted each time a test tube is attached to or detached from the analyzer, a problem arises in that differences among mounting positions may destabilize the homogeneity of a static magnetic field in an NMR signal detection area. In order to circumvent this problem, NMR analyzers using test tubes are typically provided with a rotating device for rotating a test tube (for example, an air introducing unit for blowing air against a fin formed on the test tube), whereby a test tube is rotated around an axis thereof by the rotating device in order to average the magnetic field in the NMR signal detection area. In contrast, according to the embodiment described above, by sequentially feeding samples of a plurality of types to the solution feeding pipe 18, NMR signals of the samples of the plurality of types can be acquired using the solution feeding pipe 18 fixed to the vacuum container 12 while maintaining homogeneity of the magnetic field. Therefore, a conventional rotating device can be omitted and a compact configuration can be achieved.

While a configuration comprising two heat shields 10 and 11 is described in the present embodiment, the present invention is not limited thereto. For example, only one heat shield can be used as long as intrusion of heat to the helium container 9 can be suppressed to a desired level. Using only one heat shield is preferable from the perspective of compactifying the NMR analyzer 1.

The specific embodiment described above primarily includes an invention configured as described below.

In order to solve the problem described above, the present invention provides an NMR analyzer for clinical examinations for analyzing a liquid sample including a liquid component extracted from a human body, the NMR analyzer for clinical examinations comprising: a solution feeding device that feeds a liquid sample; a solution feeding pipe that receives the liquid sample fed from the solution feeding device and that derives the liquid sample in accordance with a feeding operation of the solution feeding device; a superconducting magnet that encloses, around an axis of the solution feeding pipe, a housing space surrounded by a side wall of the solution feeding pipe such that a static magnetic field along the axis of the solution feeding pipe is generated inside the housing space; a housing container that houses the superconducting magnet and a coolant for cooling the superconducting magnet and that encloses the housing space around the axis of the solution feeding pipe; a main body container that has a negative pressure chamber whose interior is set to a negative pressure and that houses the housing container inside the negative pressure chamber and holds the solution feeding pipe by enclosing the solution feeding pipe around the axis thereof; a covering container that covers the housing container inside the negative pressure chamber; a cooling device that recondenses a coolant vaporized inside the housing container and that cools the covering container; a magnetic field correcting coil that is provided between the main body container and the solution feeding pipe and that corrects the static magnetic field generated inside the housing space by the superconducting magnet; a resonant circuit that includes a detecting coil enclosing the housing space around the axis of the solution feeding pipe between the solution feeding pipe and the magnetic field correcting coil, and applies high-frequency electromagnetic waves to a liquid sample inside the housing space, and that detects an NMR signal from the liquid sample; a transmitting/receiving unit that supplies high-frequency power to the resonant circuit and that receives an NMR signal from the resonant circuit; and a signal analyzing unit that creates data regarding a relationship between frequency and signal intensity based on the NMR signal received by the transmitting/receiving unit, wherein cooling of the covering container by the cooling device suppresses intrusion of heat from the outside into the housing container that is covered by the covering container, and by sequentially feeding a plurality of liquid samples of different types by the solution feeling device into the housing space, NMR signals of liquid samples inside the housing space can be sequentially detected.

According to the present invention, since a cooling device for cooling the covering container is provided, intrusion of heat from the outside to the housing container that is covered by the covering container can be suppressed by cooling the covering container with the cooling device. As a result; according to the present invention, a liquid nitrogen container need not be separately provided outside the housing container as was conventional, and a configuration that is more compact than conventional NMR analyzers with a liquid nitrogen container can be achieved.

Furthermore, with the present invention, a liquid sample can be fed from the solution feeding device into the housing space of the solution feeding pipe and an NMR signal of the liquid sample in the housing space can be acquired. Therefore, by sequentially feeding a plurality of liquid samples of different types into the housing space, NMR signals of the respective liquid samples can be sequentially detected. As a result, according to the present invention, a compact configuration can be achieved in comparison to conventional NMR analyzers in which liquid samples of a plurality of types are respectively placed in different test tubes and NMR signals are acquired by sequentially replacing the test tubes. Specifically, a conventional NMR analyzer using test tubes requires attaching and detaching the test tubes to and from the analyzer. In such a case, since mounting positions of test tubes to the analyzer cannot be accurately adjusted each time a test tube is attached to or detached from the analyzer, a problem arises in that differences among mounting positions may destabilize the homogeneity of a static magnetic field in an NMR signal detection area. In order to circumvent this problem, NMR analyzers using test tubes are typically provided with a rotating device for rotating a test tube (for example, an air introducing unit for blowing air against a fin formed on the test tube), whereby a test tube is rotated around an axis thereof by the rotating device in order to average the magnetic field in the NMR signal detection area. In contrast, according to the present invention, by sequentially feeding liquid samples of a plurality of types to the solution feeding pipe, NMR signals of the liquid samples of the plurality of types can be acquired using the solution feeding pipe held by the main body container while maintaining homogeneity of the magnetic field. Therefore, according to the present invention, since a conventional rotating device can be omitted, a configuration that is more compact than conventional NMR analyzers using test tubes can be achieved.

Moreover, in the present invention, "a liquid component extracted from a human body" is a term that encompasses blood, urine, sweat, saliva, spinal fluid, organ extraction liquid, and the like.

### Industrial Applicability

According to the present invention, a compact NMR analyzer for clinical examinations which is suitable for use at medical facilities can be provided.

### Explanation of Reference Numerals

- 1: NMR analyzer for clinical examinations
- 2: magnetic field generating unit
- 3: recondensing unit (cooling device)
- 4: magnetic field correcting unit
- 6: solution feeding pump (solution feeding device)
- 7: superconducting magnet
- 8: liquid helium (coolant)
- 9: helium container (housing container)
- 10, 11: heat shield
- 12: vacuum container (main body container)
- 18: solution feeding pipe
- 19: circuit section (a part of a resonant circuit)
- 22: RF coil (a part of a resonant circuit)
- 30: spectrometer
- 31: signal generating unit (a part of a transmitting/receiving unit)
- 33: signal transmitting unit (a part of a transmitting/receiving unit)
- 34: signal receiving unit (a part of a transmitting/receiving unit)
- 35: signal analyzing unit
- 39: transmitting/receiving unit

## Claims

1. An NMR analyzer (1) for clinical examinations for analyzing a liquid sample including a liquid component extracted from a human body,
the NMR analyzer (1) for clinical examinations comprising:
a solution feeding device (6) that is configured to feed a liquid sample;
a solution feeding pipe (18) that is configured to receive the liquid sample fed from the solution feeding device (6) and to derive the liquid sample in accordance with a feeding operation of the solution feeding device (6);
a superconducting magnet (7) that encloses, around an axis of the solution feeding pipe (18), a housing space surrounded by a side wall of the solution feeding pipe (18) such that a static magnetic field can be generated inside the housing space along the axis of the solution feeding pipe;
a housing container (9) that houses the superconducting magnet (7) and a coolant (8) for cooling the superconducting magnet (7) and that encloses the housing space around the axis of the solution feeding pipe (18);
a main body container (12) that has a negative pressure chamber whose interior is set to a negative pressure and that houses the housing container (9) inside the negative pressure chamber and holds the solution feeding pipe (18) by enclosing the solution feeding pipe (18) around the axis thereof;
a covering container (10, 11) that covers the housing container (9) inside the negative pressure chamber;
a cooling device (3) that is configured to recondense a coolant (8) vaporized inside the housing container (9) and to cool the covering container (10, 11);
a magnetic field correcting coil (4c) that is provided between the main body container (12) and the solution feeding pipe (18) and that is configured to correct the static magnetic field generated inside the housing space by the superconducting magnet (7);
a resonant circuit that includes a detecting coil (22) enclosing the housing space around the axis of the solution feeding pipe (18) between the solution feeding pipe (18) and the magnetic field correcting coil (4c), and is configured to apply high-frequency electromagnetic waves to a liquid sample inside the housing space, and to detect an NMR signal from the liquid sample;
a transmitting/receiving unit (39) that is configured to supply high-frequency power to the resonant circuit and to receive an NMR signal from the resonant circuit;
a signal analyzing unit (35) that is configured to create data regarding a relationship between frequency and signal intensity based on the NMR signal received by the transmitting/receiving unit (39);
a pair of upper and lower fixing plates (17a, 17b) holding the solution feeding pipe (18);
insertion holes (17c, 17d) respectively formed in the fixing plates (17a, 17b), the insertion holes (17c, 17d) vertically penetrating the fixing plates (17a, 17b) in order to allow the solution feeding pipe (18) to be inserted; and
vertically-penetrating holes formed in the fixing plates (17a, 17b) in addition to the insertion holes (17c, 17d), through which air can be pumped for temperature control of the solution feeding pipe, wherein
cooling of the covering container (10, 11) by the cooling device (3) suppresses intrusion of heat from the outside into the housing container that is covered by the covering container (10, 11), and by sequentially feeding a plurality of liquid samples of different types by the solution feeding device (6) into the housing space, NMR signals of liquid samples inside the housing space can be sequentially detected.

## Patentansprüche

1. NMR-Analysegerät (1) für klinische Untersuchungen zur Analyse einer Flüssigkeitsprobe, einschließlich einer einem menschlichen Körper entnommenen flüssigen Komponente,
das NMR-Analysegerät (1) für klinische Untersuchungen umfassend:
eine Lösungszuführungsvorrichtung (6), konfiguriert zum Zuführen einer Flüssigkeitsprobe;
eine Lösungszuführungsleitung (18), konfiguriert zum Aufnehmen der Flüssigkeitsprobe, die vom Lösungszuführungsgerät (6) zugeführt wurde, und zum Ableiten der Flüssigkeitsprobe gemäß einem Zuführungsvorgang der Lösungszuführungsvorrichtung (6);
einen supraleitender Magnet (7), der um eine Achse der Lösungszuführungsleitung (18) herum einen Gehäuseraum umschließt, der von einer Seitenwand der Lösungszuführungsleitung (18) umgeben ist, so dass ein statisches Magnetfeld innerhalb des Gehäuseraums entlang der Achse der Lösungszuführungsleitung generiert werden kann;
einen Gehäusebehälter (9), der einen supraleitenden Magneten (7) und ein Kühlmittel (8) zur Kühlung des supraleitenden Magneten (7) aufnimmt und der den Gehäuseraum um die Achse der Lösungszuführungsleitung (18) herum umschließt;
einen Hauptkörperbehälter (12), der eine Unterdruckkammer enthält, deren Inneres auf Unterdruck gesetzt ist, und der den Gehäusebehälter (9) innerhalb der Unterdruckkammer umschließt und die Lösungszuführungsleitung (18) hält, indem er die Lösungszuführungsleitung (18) um deren Achse herum umschließt;
einen Abdeckbehälter (10, 11), der den Gehäusebehälter (9) innerhalb der Unterdruckkammer bedeckt;
eine Kühlvorrichtung (3), konfiguriert zum Rekondensieren eines Kühlungsmittels (8), das innerhalb des Gehäusebehälters (9) vaporisiert wird, und zum Kühlen des Abdeckbehälters (10, 11);
eine Magnetfeld-Korrekturspule (4c), die zwischen dem Hauptkörperbehälter (12) und der Lösungszuführungsleitung (18) bereitgestellt ist, und die für die Korrektur des statischen Magnetfelds, das innerhalb des Gehäuseraums durch den supraleitenden Magneten (7) generiert wird, konfiguriert ist;
einen Resonanzkreis, der eine Detektorspule (22) enthält, die den Gehäuseraum um die Achse der Lösungszuführungsleitung (18) zwischen der Lösungszuführungsleitung (18) und der Magnetfeld-Korrekturspule (4c) umschließt, und konfiguriert zur Anwendung hochfrequenter elektromagnetischer Wellen an einer Flüssigkeitsprobe innerhalb des Gehäuseraums, und zum Ermitteln eines NMR-Signals aus der Flüssigkeitsprobe;
eine Übertragungs-/Empfangseinheit (39), konfiguriert zur Versorgung des Resonanzkreises mit Hochfrequenzleistung und zum Empfang eines NMR-Signals vom Resonanzkreis;
eine Signalanalyseeinheit (35), konfiguriert zum Erstellen von Daten bezüglich des Verhältnisses zwischen Frequenz und Signalintensität basierend auf dem NMR-Signal empfangen durch die Übertragungs-/Empfangseinheit (39);
ein Paar obere und untere Befestigungsplatten (17a, 17b), die die Lösungszuführungsleitung (18) halten;
Einführungslöcher (17c, 17d), jeweils in den Befestigungsplatten (17a, 17b) gebildet, wobei die Einführungslöcher (17c, 17d) vertikal die Befestigungsplatten (17a, 17b) durchdringen, um die Lösungszuführungsleitung (18) einführen zu können; und
vertikal-durchdringende Löcher gebildet in den Befestigungsplatten (17a, 17b) zusätzlich zu den Einführungslöchern (17c, 17d), durch die Luft zur Temperaturkontrolle der Lösungszuführungsleitung gepumpt werden kann, wobei
die Kühlung des Abdeckbehälters (10, 11) durch die Kühlvorrichtung (3) das Eindringen von Wärme von außerhalb in den Gehäusebehälter, der vom Abdeckbehälter (10, 11) bedeckt wird, unterdrückt, und durch das fortlaufende Zuführen einer Vielzahl an Flüssigkeitsproben verschiedener Arten durch das Lösungszuführungsgerät (6) in den Gehäuseraum NMR-Signale der Flüssigkeitsproben innerhalb des Gehäuseraums fortlaufend ermittelt werden können.

## Revendications

1. Analyseur par résonance magnétique nucléaire (1) pour des examens cliniques pour l'analyse d'un échantillon liquide incluant un composant liquide extrait d'un corps humain,
l'analyseur par résonance magnétique nucléaire (1) pour des examens cliniques comprenant :
un dispositif d'alimentation en solution (6) qui est configuré pour alimenter un échantillon liquide ;
un tuyau d'alimentation en solution (18) qui est configuré pour recevoir l'échantillon liquide alimenté depuis le dispositif d'alimentation en solution (6) et pour dériver l'échantillon liquide conformément à une opération d'alimentation du dispositif d'alimentation en solution (6) ;
un aimant supraconducteur (7) qui renferme autour d'un axe du tuyau d'alimentation en solution (18) un espace de logement entouré par une paroi latérale du tuyau d'alimentation en solution (18) de sorte qu'un champ magnétique statique peut être généré à l'intérieur de l'espace de logement le long de l'axe du tuyau d'alimentation en solution ;
un récipient de logement (8) qui héberge l'aimant supraconducteur (7) et un réfrigérant (8) pour refroidir l'aimant supraconducteur (7) et qui renferme l'espace de logement autour de l'axe du tuyau d'alimentation en solution (18) ;
un récipient de corps principal (12) qui a une chambre à pression négative dont l'intérieur est réglé sur une pression négative, et qui héberge le récipient de logement (9) à l'intérieur de la chambre à pression négative et maintient le tuyau d'alimentation en solution (18) en renfermant le tuyau d'alimentation en solution (18) autour de l'axe de celui-ci ;
un récipient de recouvrement (10, 11) qui recouvre le récipient de logement (9) à l'intérieur de la chambre à pression négative ;
un dispositif de refroidissement (3) qui est configuré pour recondenser un réfrigérant (8) évaporé à l'intérieur du récipient de logement (9) et pour refroidir le récipient de recouvrement (10, 11) ;
une bobine de correction de champ magnétique (4c) qui est prévue entre le récipient de corps principal (12) et le tuyau d'alimentation en solution (18), et
qui est configurée pour corriger le champ magnétique statique généré à l'intérieur de l'espace de logement par l'aimant supraconducteur (7) ;
un circuit résonant qui inclut une bobine de détection (22) renfermant l'espace de logement autour de l'axe du tuyau d'alimentation en solution (18) entre le tuyau d'alimentation en solution (18) et la bobine de correction de champ magnétique (4c), et est configuré pour appliquer des ondes électromagnétiques à haute fréquence à un échantillon liquide à l'intérieur de l'espace de logement et
pour détecter un signal de résonance magnétique nucléaire provenant de l'échantillon liquide ;
un module de transmission/réception (39) qui est configuré pour fournir de la puissance à haute fréquence au circuit résonant et pour recevoir un signal de résonance magnétique nucléaire du circuit résonant ;
un module d'analyse de signal (35) qui est configuré pour créer des données concernant une relation entre fréquence et intensité de signal en fonction du signal de résonance magnétique nucléaire reçu par le module de transmission/réception (39) ;
une paire de plaques de fixation supérieure et inférieure (17a, 17b) maintenant le tuyau d'alimentation en solution (18) ;
des orifices d'insertion (17c, 17d) formés respectivement dans les plaques de fixation (17a, 17b), les orifices d'insertion (17c, 17d) pénétrant verticalement dans les plaques de fixation (17a, 17b) afin de permettre au tuyau d'alimentation en solution (18) d'être inséré ; et
des orifices de pénétration verticale formés dans les plaques de fixation (17a, 17b) outre les orifices d'insertion (17c, 17d), à travers lesquels de l'air peut être pompé pour la commande de température du tuyau d'alimentation en solution,
dans lequel
le refroidissement du récipient de recouvrement (10, 11) par le dispositif de refroidissement (3) supprime l'intrusion de chaleur provenant de l'extérieur dans le récipient de logement qui est recouvert par le récipient de recouvrement (10, 11), et en alimentant de manière séquentielle une pluralité d'échantillons liquides de différents types par le dispositif d'alimentation en solution (6) dans l'espace de logement, des signaux de résonance magnétique nucléaire d'échantillons liquides à l'intérieur de l'espace de logement peuvent être détectés de manière séquentielle.
